(19) Europäisches Patentamt / European Patent Office / Office européen des brevets

(11) **EP 3 940 863 A1**

(12) **EUROPEAN PATENT APPLICATION**

(43) Date of publication:
**19.01.2022 Bulletin 2022/03**

(21) Application number: **21182650.8**

(22) Date of filing: **30.06.2021**

(51) International Patent Classification (IPC):
$H01M\ 10/42^{(2006.01)}$    $H01M\ 10/48^{(2006.01)}$
$H01M\ 10/617^{(2014.01)}$    $H01M\ 10/625^{(2014.01)}$
$H01M\ 10/633^{(2021.01)}$    $H01M\ 10/651^{(2014.01)}$
$H01M\ 50/213^{(2021.01)}$    $H01M\ 50/233^{(2021.01)}$
$H01M\ 50/249^{(2021.01)}$    $G01R\ 31/385^{(2019.01)}$
$G01R\ 31/389^{(2019.01)}$

(52) Cooperative Patent Classification (CPC):
H01M 10/482; G01R 31/3865; G01R 31/389;
H01M 10/4285; H01M 10/617; H01M 10/625;
H01M 10/633; H01M 10/651; H01M 50/213;
H01M 50/233; H01M 50/249; H01M 2220/20

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **16.07.2020   GB 202010946**

(71) Applicant: **Rolls-Royce plc
London N1 9FX (GB)**

(72) Inventor: **Bingham, Timothy
Derby, DE24 8BJ (GB)**

(74) Representative: **Rolls-Royce plc
Intellectual Property Dept SinA-48
PO Box 31
Derby DE24 8BJ (GB)**

(54) **BATTERY PACK ASSEMBLY METHOD**

(57)    A method 60 of assembling a battery pack from a plurality of battery cells of a same type is provided. The method may account for normal variation in the DC internal resistance of the cells and thereby improve the battery pack's performance. The method comprises: identifying 61 a design for at least a portion of a battery pack, wherein the portion includes a plurality of battery cells and the design defines, for each of the plurality of cells, a cell position within the portion of the battery pack; obtaining 62 a thermal model for the portion of the battery pack, the thermal model including, for each of the plurality of cell positions, a measure of a cooling capability associated with the cell position; obtaining 63 a plurality of battery cells of the same type; obtaining 64, for each of the obtained battery cells, an indication of at least one measured property of the cell, the at least one measured property of the cell including a DC internal resistance of the cell; for a plurality of the cell positions, allocating 65 one of the obtained cells to the cell position based at least in part on the thermal model and the DC internal resistances of the cells; and assembling 66 the portion of the battery pack in accordance with the design and the allocations of the obtained cells.

*FIG. 5A*

EP 3 940 863 A1

# Description

## Technical Field

The present disclosure relates to methods of assembling battery packs, more particularly to the assembly of battery packs from a plurality of battery cells of the same type.

## Background

Future aerospace applications including more electric, hybrid electric and purely electric aircraft will likely use high voltage battery packs made up of a number of series-connected and/or parallel-connected battery modules. These battery packs may be used to power one or more motors used to propel the aircraft and/or to provide power to one or more ancillary systems.

For safety reasons it is necessary to operate a battery pack below the thermal limits of the battery cells that make up the pack/modules. Improving the performance of a battery pack will thus generally require one or more of the following measures:

- Adding more cells to the battery pack to increase the charge capacity, the terminal voltage and/or the current that can be safely drawn from the pack. However adding cells increases the size and weight of the battery pack, which may be particularly problematic in aerospace applications.

- Improving the cooling of the cells so that an increased current can be drawn without the cells overheating. However there are practical limits and <u>e.g.</u> increasing cell spacing and/or adding further cooling systems may increase the size, weight and complexity of the pack.

- Operating the battery pack closer to the temperature limits of the cells. This may not require any changes to the design of the battery pack but may be unacceptable from a safety perspective.

## Summary

The present disclosure provides battery pack assembly methods that may account for normal variation in cell properties and may improve battery pack performance without the need to operate the pack closer to its thermal limit.

According to a first aspect, there is provided a method of assembling a battery pack from a plurality of battery cells of a same type, the method comprising: identifying a design for at least a portion of a battery pack, wherein the portion includes a plurality of battery cells and the design defines, for each of the plurality of cells, a cell position within the portion of the battery pack; obtaining a thermal model for the portion of the battery pack, the thermal model including, for each of the plurality of cell positions, a measure of a cooling capability associated with the cell position; obtaining a plurality of battery cells of the same type; obtaining, for each of the obtained battery cells, an indication of at least one measured property of the cell, the at least one measured property of the cell including a DC internal resistance of the cell; for a plurality of the cell positions, allocating one of the obtained cells to the cell position based at least in part on the thermal model and the DC internal resistances of the cells; and assembling the portion of the battery pack in accordance with the design and the allocations of the obtained cells.

While cells of a same type are ostensibly identical, even high-quality cells that have been carefully manufactured exhibit some variation in properties such as DC internal resistance. This normal variation in DC internal resistance may contribute to the battery pack's temperature delta (i.e. the difference in temperature between the hottest and coolest cell of the pack), as cells with higher DC internal resistances may become hotter. By allocating cells with high internal resistances to cell positions with the best cooling capabilities, and vice versa, the temperature delta may be reduced. If the temperature delta is reduced then the average cell temperature will be closer to the maximum cell temperature. This may mean an increase in performance can be obtained without adding cells and without operating any single cell closer to its thermal limit.

Allocating the obtained cells to the cell positions may comprise allocating cells having a relatively lower DC internal resistance to cell positions having a relatively higher cooling capability and allocating cells having a relatively higher DC internal resistance to cell positions having a relatively lower cooling capability.

The cells may be allocated to cell positions so as to reduce a predicted temperature delta across the portion of the battery pack. The temperature delta may be a difference between a temperature of a hottest cell in the portion of the battery pack and a temperature of a coolest cell in the portion of the battery pack.

The thermal model may include, for each of the plurality of cell positions, an indication of which one of a plurality of groups the cell position is associated with, wherein each of the plurality of groups corresponds to a different level of cooling capability.

Each of the plurality of groups may contain a plurality of cell positions whose positions are descriptively equivalent to all other cell positions in the group.

Two cell positions may be considered to be descriptively equivalent if they both meet one or more predefined criteria.

The one or more predefined criteria may be based on or more of: whether or not a cell position is completely surrounded by other cell positions; a number of cells positions that immediately neighbour the cell position; and/or a distance between the cell position and an exposed edge of the battery pack.

The thermal model may include, for each cell position, a ranking of the cell position's cooling capability compared to the other cell positions.

The at least one measured property may include a charge capacity of the cell.

The indication of the at least one measured property of the cell may include the DC internal resistance of the cell and, optionally, a charge capacity of the cell.

The indication of the at least one measured property of the cell may include a ranking of the cell's DC internal resistance compared to the other cells and, optionally, a ranking of the cell's charge capacity compared to the other cells.

The indication of the at least one measured property of the cell may include a performance metric based on the cell's DC internal resistance and charge capacity.

The indication of the at least one measured property of the cell may include an indication of which one of a plurality of performance brackets the cell falls into, wherein each performance bracket comprises at least one cell, and wherein the performance bracket into which a cell falls is based at least in part on the cell's DC internal resistance.

The indication of the at least one measured property of the cell may be or may be based on a performance metric. The performance metric may be a weighted sum of the cell's DC internal resistance and the cell's capacity or rankings thereof.

The term "battery pack" is used in a general sense and may be any battery assembly that includes an organised arrangement of battery cells. Said at least a portion of the battery pack may be the whole battery pack; one or more modules of the battery pack; or any subset of a set of cells, the set of cells including all cells of the battery pack. In other words, the assembly method may be applied to a whole battery pack or to only a portion of the battery pack, for instance one or more modules or another sub-unit of the battery pack.

According to a second aspect there is provided a battery pack or a portion of battery pack assembled according to the first aspect.

According to a third aspect there is provided a computer program which, when executed by a computer, is operable to: receive a first input comprising a thermal model of at least a portion of a battery back, the thermal model including, for each of a plurality of battery cell positions of the portion of the battery pack, a measure of a cooling capability associated with the cell position; receive a second input comprising, for each of a plurality of battery cells, an indication of at least one measured property of the cell, the at least one measured property including a DC internal resistance of the cell; determine, for each of the cell positions of the thermal model, and based at least in part on the thermal model and the indications of the at least one measured property of the cells, a cell to cell position allocation; and output the allocations.

The computer program may be stored on a non-transitory computer readable medium.

The skilled person will appreciate that except where mutually exclusive, a feature described in relation to any one of the above aspects may be applied mutatis mutandis to any other aspect. Furthermore except where mutually exclusive any feature described herein may be applied to any aspect and/or combined with any other feature described herein.

## Brief Description of the Drawings

Embodiments will now be described by way of example only, with reference to the Figures, in which:

**Figure 1** is a sectional side view of a gas turbine engine;

**Figure 2A** is a schematic illustration of a hybrid electric aircraft propulsion system;

**Figure 2B** is a schematic illustration of a purely electric aircraft propulsion system;

**Figure 3** illustrates components of a three-channel modular battery pack;

**Figure 4** is a perspective view of the battery pack of Figure 3;

**Figure 5A** illustrates cell positions within a module of the battery pack of Figures 3-4;

**Figure 5B** is a graph depicting how the temperature of a cell may change during discharge;

**Figure 6** is a flow chart illustrating a series of measurements performed on battery cell;

**Figure 7** is a flow chart illustrating how cells may be selected for use and allocated to cell positions within a battery pack;

**Figure 8A** is a bar chart illustrating variation in the DC internal resistance of cells of the same type;

**Figure 8B** is a bar chart illustrating variation in the capacity of cells of the same type; and

**Figure 9** is a flow chart illustrating a method of assembling a battery pack in accordance with the present disclosure.

## Specific Description

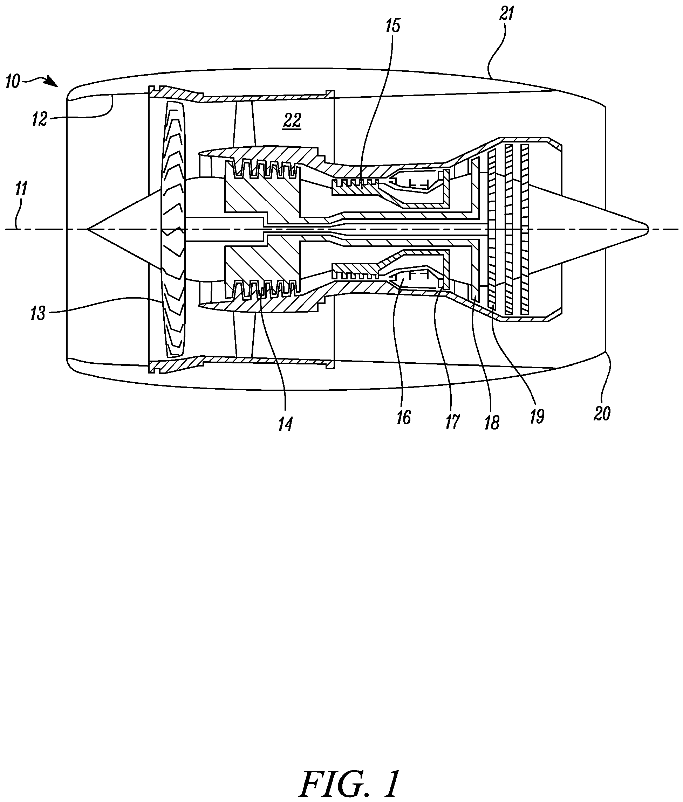

With reference to **Figure 1,** a gas turbine engine is generally indicated at 10, having a principal and rotational axis 11. The engine 10 comprises, in axial flow series, an air intake 12, a propulsive fan 13, an intermediate pressure compressor 14, a high-pressure compressor 15, combustion equipment 16, a high-pressure turbine 17, an intermediate pressure turbine 18, a low-pressure turbine 19 and an exhaust nozzle 20. A nacelle 21 generally surrounds the engine 10 and defines both the intake 12 and the exhaust nozzle 20.

The gas turbine engine 10 works in the conventional manner so that air entering the intake 12 is accelerated by the fan 13 to produce two air flows: a first air flow into the intermediate pressure compressor 14 and a second air flow which passes through a bypass duct 22 to provide propulsive thrust. The intermediate pressure compressor 14 compresses the air flow directed into it before delivering that air to the high pressure compressor 15 where further compression takes place.

The compressed air exhausted from the high-pressure compressor 15 is directed into the combustion equipment 16 where it is mixed with fuel and the mixture combusted. The resultant hot combustion products then expand through, and thereby drive the high, intermediate and low-pressure turbines 17, 18, 19 before being exhausted through the nozzle 20 to provide additional propulsive thrust. The high 17, intermediate 18 and low 19 pressure turbines drive respectively the high pressure compressor 15, intermediate pressure compressor 14 and fan 13, each by suitable interconnecting shaft.

Other gas turbine engines to which the present disclosure may be applied may have alternative configurations. By way of example such engines may have an alternative number of interconnecting shafts (e.g. two) and/or an alternative number of compressors and/or turbines. Further the engine may comprise a gearbox provided in the drive train from a turbine to a compressor and/or fan. The gas turbine engine may also incorporate or interface with one or more batteries, for example to power ancillary electrical systems and/or to cooperate with one or more electric machines involved in the transfer of mechanical power to and from one or more of the interconnecting shafts.

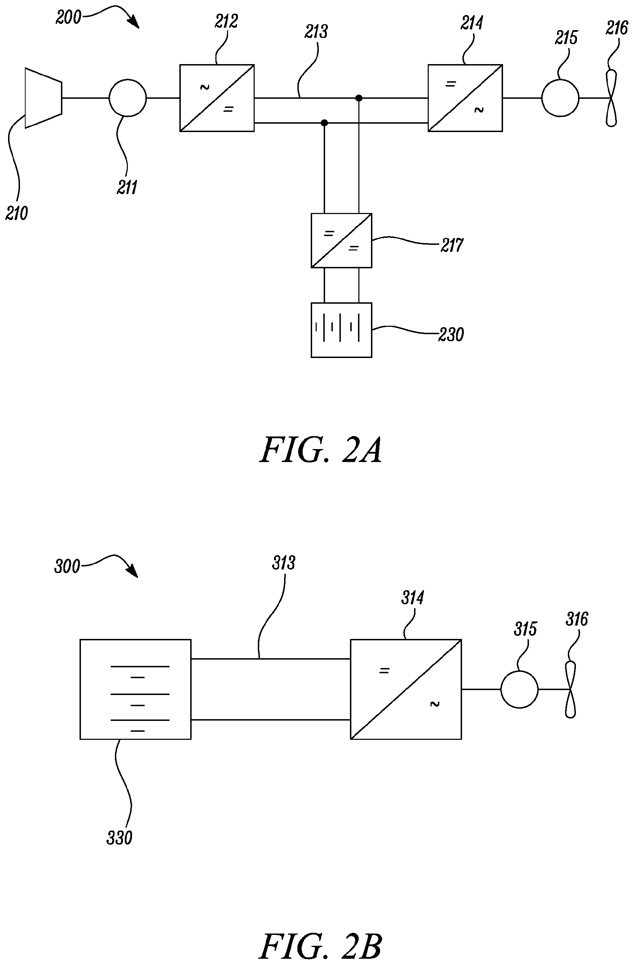

Now referring to **Figure 2A,** the propulsion system of a hybrid electric aircraft is generally indicated at 200 and incorporates both an engine 210, such as the gas turbine engine 10 described above with reference to Figure 1, and a battery pack 230. Both the engine 210 and the battery pack 230 are used as energy sources to power a motor-driven propeller 216, as well as ancillary electrical systems (not shown). The propulsion system 200 of the hybrid electric aircraft will typically further comprise a generator 211, an AC/DC converter 212, a high voltage DC (HVDC) distribution bus 213, a DC/AC converter 214, a motor 215 that drives the propeller 216, and a DC/DC converter 217.

A shaft of the engine 210 is coupled to and drives the rotation of a shaft of the generator 211 which thereby produces alternating current. The AC/DC converter 212, which faces the generator 211, converts the alternating current into direct current which is fed to various electrical systems via the HVDC distribution bus 213. These electrical systems include the motor 215 that drives the propeller 216. The motor 215 will typically be a synchronous motor that interfaces with the HVDC distribution bus 213 via the DC/AC converter 214.

The battery pack 230, which may be made up of a number of lithium ion battery modules connected in series and/or parallel, is connected to the HVDC distribution bus 213 via the DC/DC converter 217. The DC/DC converter 217 converts between a voltage of the battery pack 230 and a voltage of the HVDC distribution bus 213. In this way, the battery pack 230 can replace or supplement the power provided by the engine 210 (by discharging and thereby feeding the HVDC distribution bus 213) or can be charged using the power provided by the engine 210 (by being fed by the HVDC distribution bus 213).

A battery pack will also appear in the propulsion system of a purely electric aircraft, generally indicated as 300 in **Figure 2B.** The battery pack 330 feeds a HVDC distribution bus 313, possibly via DC/DC converter (not shown), which delivers power to one or more synchronous motors 315 via a DC/AC converter 314. The one or more motors 315 drive the one or more propellers 316 that propel that aircraft.

Battery packs used in these applications typically require high charge capacities, as well high terminal voltages (e.g. 500V to 3kV) which allows for a reduction in the weight of the power distribution cabling. Obtaining high charge capacities and high terminal voltages typically necessitates the use of a large number of battery cells (e.g. conventional 4.2V 18650 cylindrical cells) connected together in series and parallel.

Where possible, it is generally preferable to limit the number of cells in the battery pack in order to limit its physical size and weight. However, the desire to limit the number of cells must be balanced against the need to meet the design specification and to operate the battery pack safely, in particular below the thermal limits of the cells. Thus, if a desired current can only be drawn from a battery pack by exceeding a predefined safety margin below the thermal limit of the cells, it will generally be necessary to increase the number of cells despite the associated undesirable increase in size and weight.

The present disclosure provided a battery pack assembly method which may allow the performance of a battery pack to be improved without requiring an increase in the number of cells and without reducing the margin of safe operation.

The present disclosure recognises that although cells of a given type are designed to be identical, their DC internal resistances slightly vary and that this may contribute to the cell temperature delta across the battery pack. The present disclosure proposes to measure the DC internal resistances of the cells prior to assembly of a battery pack and to allocate each cell to a particular position (or to a particular class of position) within the battery pack based on the DC internal resistances of the cells and a thermal model of the battery pack. Cells having the lowest DC internal resistance may occupy the most thermally demanding positions (positions where cell cooling efficiency is lowest, for example) and vice versa. In this way, the battery pack temperature delta may be reduced such that the average cell temperature is closer to the maximum cell temperature. Overall, this may allow for a larger current to be drawn from the battery pack without any cell temperatures exceeding a safe operating threshold.

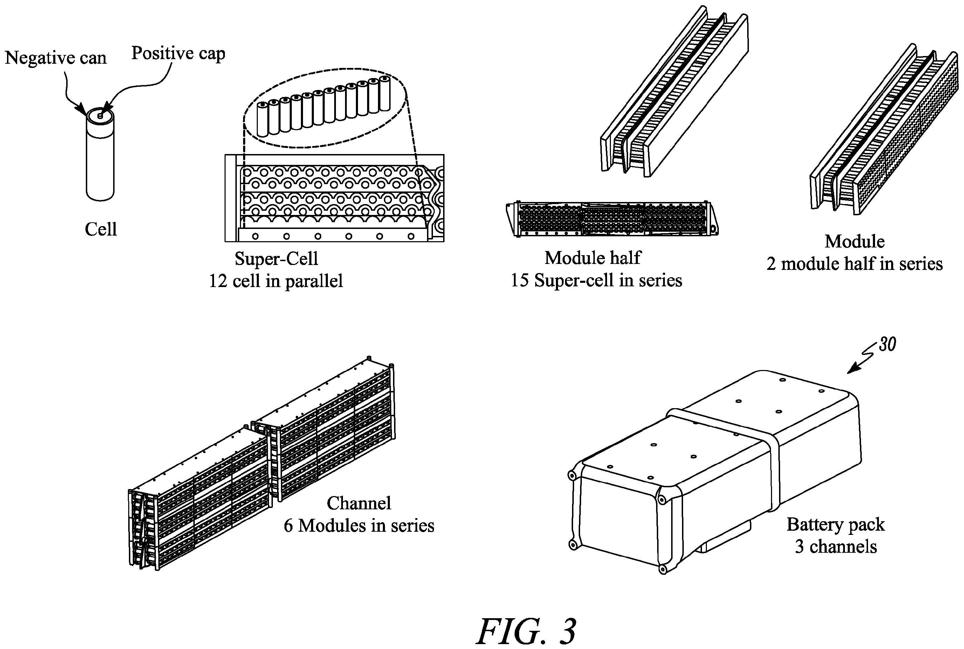

It is to be understood that the present disclosure may be applied to the assembly of an entire battery pack or to a portion of a battery pack, for example a module or part of a module. It may be applied to any battery assembly that includes a plurality of cells, typically arranged in an array, that are of the same type. It will be understood that the terms "cells of a common type" and "cells of a same type" refer to cells that are ostensibly identical, for example cells of the same specification made by the same manufacturer. Specific examples will now be described with reference to Figures 3-9.

**Figure 3** shows the design of an exemplary battery pack 30. It is to be understood that the design shown in Figure 3 is not intended to limit the present disclosure, but rather to illustrate how a battery pack may be constructed from a plurality of cells of a common type.

Referring first to the top row of images, the leftmost image shows a single battery cell, in this case a 4.2V 18650 cylindrical cell having positive and negative terminals located at the same top end of the cell. In the next image, twelve of the cells are provided in a row and are connected in parallel, via a collector in the form of a bus bar adjacent to the row, to form a super-cell. Five super-cell rows are then connected together in series to form a five-row array of super-cells having a total voltage of about 20V and including sixty tightly packed cylindrical cells.

In the next image, three of these arrays (totalling fifteen super-cells) are connected together in series to form a module-half having a terminal voltage of about 60V. In the final image of the top row, two of the module-halves are connected together in series to form a battery module having a terminal voltage of approximately 120V. It will be appreciated that, in this example, the battery module includes 360 of the cylindrical cells. A substantially flat cooling plate is provided between the two module-halves to cool the cells of both halves at their flat bottom ends.

Now referring to the bottom row of images, in the left hand image a battery channel is formed by connecting six of the battery modules together in series. The channel thus has a terminal voltage of about 720V and consists of 2,160 cells. Finally, in the right hand image, a battery pack 30 includes a battery case that houses three of the battery channels. That is, the battery pack 30 includes three independent 720V power supplies each having 2,160 battery cells, for a total of 6,480 cells. It will of course be appreciated that the battery pack could have any number of channels, including one channel.

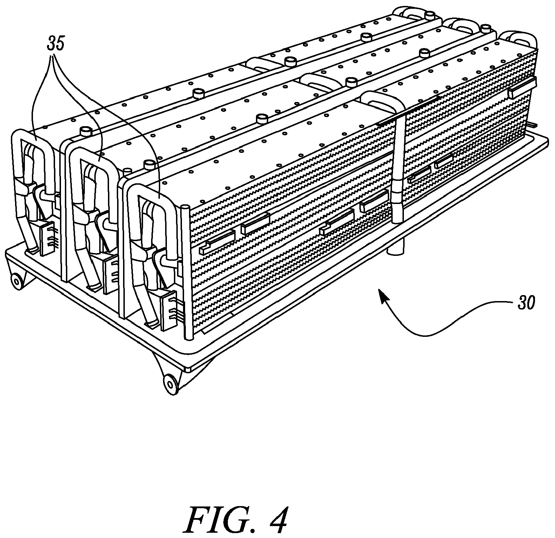

**Figure 4** shows a battery pack 30, identical to the battery pack 30 in the final image of Figure 3 but with the top of the protective case removed. Further details of the battery pack 30 are visible in Figure 4, including conduits 35 for carrying a cooling fluid that is directed through the cooling plates that are sandwiched between module-halves. As noted above, one such cooling plate is visible in the right-most image of the top row of Figure 3, separating the two-module halves.

The design and locations of the cooling plates have been selected to provide substantially uniform cooling to all of the cells of the battery pack 30. This is generally desirable because each cell has the same terminal voltage and, in use, will supply the same share of the current drawn from the battery channel. Despite this design, however, it can be appreciated that not every cell is in an identical thermal environment (i.e. the cell cooling capability varies between cell positions). It can be seen that some cells are substantially surrounded by other cells, whereas other cells are located at module edges and are thus only partially surrounded by cells. The latter may be associated with better cooling. Some cells are also located closer to the cooling plate inlet conduits, which may provide additional cooling. Other cells may be located adjacent or close to other heat-generating components, which may reduce the cooling capability in certain cell positions and/or create hot spots.

These differences in thermal environment may mean that some cell positions are associated with a better cooling capability than other cell positions. In accordance with the present disclosure, each cell position in the battery pack (or each cell position in the portion of the battery pack to which the method is to be applied) is assigned a measure of its thermal environment (i.e. its cooling capability). The set of measures may be referred to as a thermal model. Cells determined to have higher DC internal resistances, which may thus be more susceptible to heating, are then allocated to cell positions associated with good cooling capabilities so as to more readily dissipate the extra heat they produce.

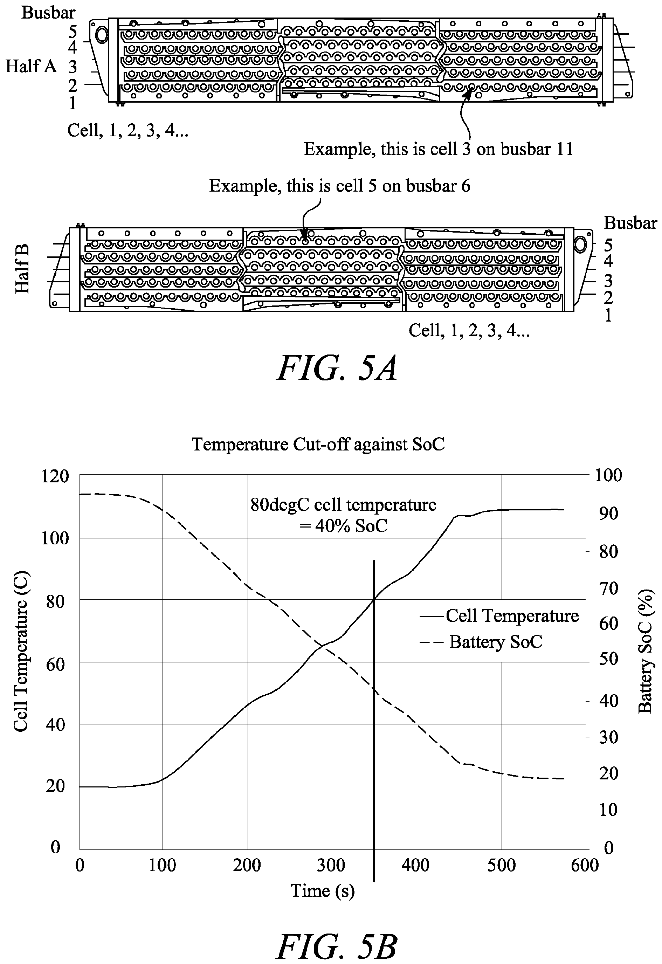

**Figures 5A and 5B** illustrate how a thermal model may be defined for a battery pack, in particular for one module of one channel of the battery pack illustrated in Figures 3 and 4.

**Figure 5A** is a top down view of the two-module halves, Half A and Half B. Each module half includes fifteen series-connected bus bars and each bus bar is associated with twelve parallel-connected cells. Each cell has a unique position within the module, and the position can be assigned a unique identifier. Any identification system could be used, but in one example each cell is identified by its half (A or B) - its bus bar number (1 to 15) - and its cell number (1 to 12). Cells A-11-3 and B-6-5 are labelled in Figure 5A by way of example. It will be appreciated that this could be extended to the entire battery pack, and indeed to any other battery assembly constructed using similar principles.

Having defined cell positions, a module thermal model can be generated by assigning, to each cell position, a measure of a cooling capability associated with the cell position. The measure of the cooling capability of a cell position could take any number of forms, including but not limited to:

- A cooling rate value (e.g. measured in Watts) associated with the cell position. Cooling rates may be determined by measurements performed on a prototype battery pack (or a partial prototype) or predicted by a computer model or simulation of the battery module.

- A numerical ranking based on the determined cooling rate. For instance, having determined a cooling rate for each of the 360 cell positions of the module of Figure 5A, the cells could be ranked from 1 (highest cooling rate) to 360 (lowest cooling rate).

- A grouping based on the determined cooling rate. For instance: the 36 cells with the 36 highest cooling rates could be assigned to Group A; the 36 cells with 36 next highest cooling rates could be assigned to Group B; ...; and the 36 cells with the lowest 36 cooling rates could be assigned to Group J. These groups could all be of equal size or could be of different sizes.

- Another value, determined by measurement or by a computer model or simulation, which may be related to the cooling rate. For instance, referring to **Figure 5B,** there is shown a graph illustrating how the temperature of a cell in a particular cell position within the battery module varies as it is discharged from about 90% State of Charge (SoC) at a predefined current. The predefined current has been selected based on an expected operating profile of the battery pack. The recommended maximum operating temperature of the cell, in this case 80 °C, occurs after about 350 seconds and at about 40% SoC. Either of these values (the time or SoC at which the temperature limit is reached) may be used as a proxy measure of the cooling capability of the cell position: it will generally be expected that a longer time and a lower SoC will indicate a better cooling capability.

- A numerical ranking or grouping based on the e.g. time or SoC at which the cell reaches its temperature limit.

- Descriptively equivalent (or similar) cell positions within the module may be identified and all cells meeting a particular description assigned to the same group. The groups can further be assigned a ranking based on a predicted or measured cooling capability for that group. For example:

  i. Two groups of cell positions may be defined: cell positions located at an edge of the module (i.e. cells exposed on at least one side) and cell positions located in the core of the module (i.e. cells surrounded on all sides by other cells). Cell positions located at edges may be expected to have better cooling capabilities, so may be referred to as Group A, and the group of core cell positions may be expected to have lesser cooling capabilities, so may be referred to as Group B.

  ii. Three groups may be defined: cell positions located on long edges of the module; cells located on the short edges of the module; and surrounded cells located in the core of the module. It may be expected that cells positions located on short edges are associated with better cooling, so may be referred to as Group A. Cell positions on long edges may then be Group B and core cell positions Group C.

  iii. More or fewer groups may be defined based on various criteria. Example criteria include but are not limited to whether or not the cell is at an edge, the number of cells that neighbour the cell position, the distance from the centre of the cell position to a nearest edge and the distance from the centre of the cell positon to one or more predicted hotspots.

In summary, a thermal model of a battery module (or channel, pack, pack portion or any assembly of cells of the same type) is determined by assigning each cell position a measure of the cell cooling capability associated with that cell position. The measure may be an absolute value (cooling rate in Watts or a proxy measure as discussed above), a ranking or a grouping. The values, ranking and groupings may be based on actual measurements, computer modelling or a descriptive approach (e.g. groups of descriptively similar or equivalent cell positions, ranked based on a measured or predicted level of cooling capability).

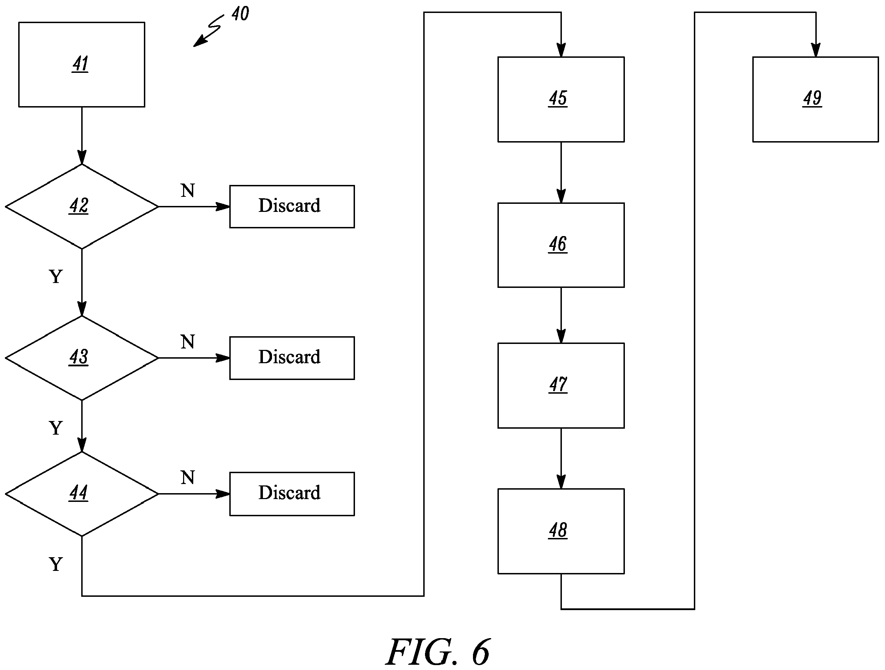

In accordance with the present disclosure, as well as obtaining a thermal model of a portion of a battery pack, it is necessary to obtain measures of cell properties of the cells from which the portion of the pack is to be assembled. To this end, **Figure 6** is a flow chart illustrating an exemplary process 40 for measuring properties of a battery cell. Some or all of the steps of the flow chart 40 may be performed for each of a plurality of obtained cells of a common type. The cell type may, for example, be an 18650 cylindrical cell. The process starts at 41.

At 42, a visual inspection of the cell is performed to check for any obvious defects or damage to the cell. If the cell is not visually acceptable it is discarded. If it is visually acceptable, the process continues at 43.

At 43, the cell is weighed to check that its mass is within a predefined normal range. If it is not, the cell is discarded. If it is, the process continues at 44.

At 44, the open circuit voltage of the cell is measured and compared to an expected value (e.g. 4.2V). If the measured open circuit voltage is not within an acceptable range, it is discarded. If it is, the process continues at 45.

At 45, the cell is assigned a unique identifier. Any identifier could be used, for example a number. The cell may be physically marked with the identifier, for example a number or a barcode.

At 46, the cell is fully charged, for example by charging it for a predefined amount of time in accordance with the manufacturer's specification.

At 47, the cell is discharged and its total capacity recorded against its unique identifier.

At 48, the cell is charged. It may, for example, be charged to 40% SoC or any other suitable SoC, though preferably the same SoC is used for each cell. After charging, at 49 a DC internal resistance measurement is performed on the cell and the resistance recorded against the cell's unique identifier. Methods of measuring the DC internal resistance of battery cells are well-known and any suitable method may be used.

The result of the process 40 is a collection of cells of the same type, where each cell has a unique identifier associated with a capacity measurement and a DC internal resistance measurement. In view of steps 42, 43 and 44, damaged cells and cells deviating from the basic cell specification have been discarded.

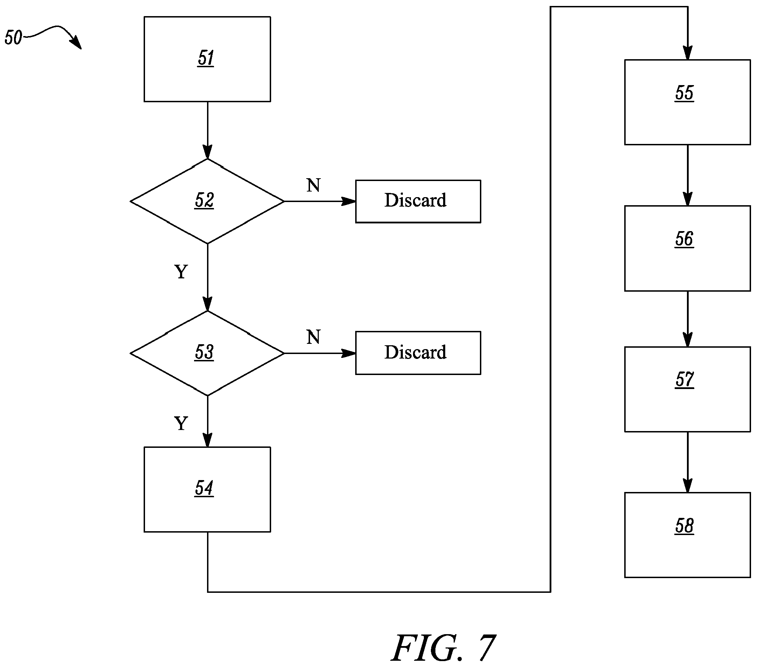

Now turning to **Figure 7,** the flow chart illustrates an exemplary process 50 for allocating cells to the cell positions of the chosen battery pack (or module or other assembly to which the method is applied). The process 50 starts at 51.

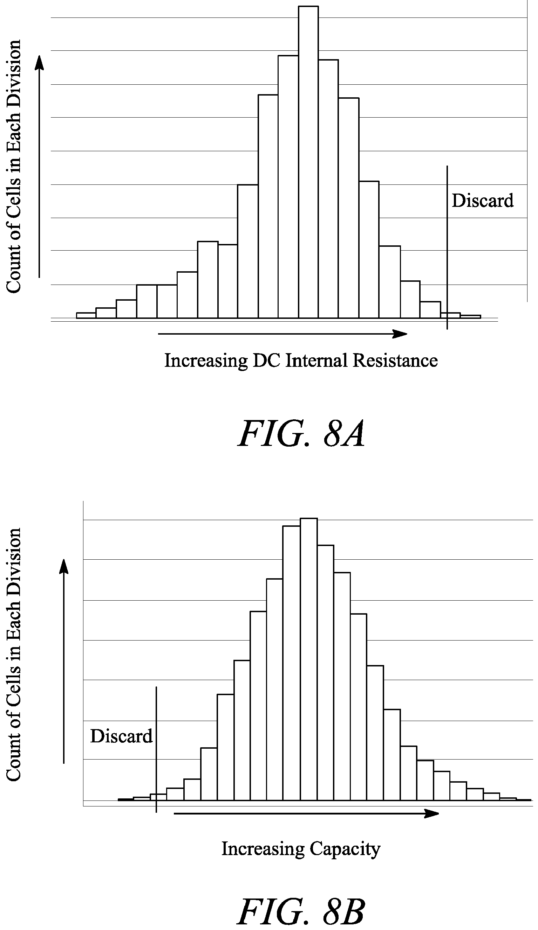

At 52, some of the cells may be discarded based on their measured DC internal resistance. This is illustrated in the bar chart of **Figure 8A.** In some examples, cells are discarded only if their DC internal resistance is higher than some predefined value. In other examples, a predefined number or percentage of cells with the highest DC internal resistance are discarded. For instance, if there are more cells than cell positions, some or all of the excess cells having the highest DC internal resistance may be discarded.

At 53, some of the remaining cells may be discarded based on their measured capacity. This is illustrated in the bar chart of **Figure 8B.** In some examples, cells are discarded only if their capacity is lower than some predefined value. In other examples, a predefined number or percentage of cells with the lowest capacity are discarded. For instance, if there are more cells than cell positions, some or all of the excess cells having the lowest capacity may be discarded.

Neither, one or both of steps 52 and 53 may be performed, and the order may be reversed.

At 54, the remaining cells are ranked based at least in part on their DC internal resistance. In one example, the cells are ranked in order of their DC internal resistance, with the cell with the lowest DC internal resistance given the highest ranking (e.g. 1).

In other examples, a performance metric is calculated for each cell and the cells are then ranked based on their performance metrics. For instance, each cell may initially be given two rankings, one for its DC internal resistance (lowest resistance corresponds to a higher ranking) and another for its capacity (higher capacity corresponds to a higher ranking). A performance metric may then calculated as a function of the two rankings:

$$P_i = f(R_{R,i}, R_{C,i})$$

Where $P_i$ is the performance metric for the i-th cell, $R_{R,i}$ is the DC internal resistance ranking of the i-th cell, $R_{C,i}$ is the capacity ranking of the i-th cell, and f is a function of $R_{R,i}$ and $R_{C,i}$. For example, the performance metric may be a weighted sum of the two rankings:

$$P_i = \alpha.R_{R,i} + \beta.R_{C,i}$$

Where $\alpha$ and $\beta$ are weighting constants. In the high power use cases expected for some aerospace applications, the thermal limit of the cells may a limiting factor. The weightings $\alpha$, $\beta$ may thus be biased towards to the DC internal resistance ranking. Once $P_i$ is calculated, the cells may be ranked based on their performance metrics. Depending on the function, a high performance metric $P_i$ may indicate relatively good or relatively poor cell characteristics.

In another example, a performance metric is calculated a function of the raw DC internal and capacity values:

$$P_i = g(R_i, C_i)$$

Where $P_i$ is the performance metric for the i-th cell, $R_i$ is the DC internal resistance of the i-th cell, $C_i$ is the capacity of the i-th cell, and g is a function of $R_i$ and $C_i$. Again, cells may be ranked once their performance metrics have been calculated. In some examples the functions f, g may account for other variables in addition to $R_i$, $C_i$, $R_{R,i}$, and $R_{C,i}$.

At 55, optionally, cells are assigned to groups (hereafter "performance brackets") based on their rankings. For example, the ten highest ranked cells may be assigned to performance bracket A; the next ten highest cells may be assigned to performance bracket 2 and so forth. These performance brackets could all be of equal size or could be of different sizes.

Assigning cells to performance brackets may be particularly preferable where the thermal model of the battery pack also includes groups. In this case, the number of performance brackets may be the same as the number of groups of cell positions in the thermal model, and a number of cells within each performance bracket may correspond to a number of cell positions within a corresponding group of the thermal model.

At 56, a one-to-one mapping of cell to cell position is performed so that one cell is allocated to each of the cell positions. The allocation is based on the thermal model of the battery module and the cell rankings output in step 54 and/or the groupings of step 55.

Where neither the thermal model nor the cell rankings includes groups or performance brackets, the allocation may proceed as follows: the cell position with the worst-ranked measure of cooling capability is allocated the best-ranked cell; the cell position with the second to worst-ranked measure of cooling capability is allocated the second-best ranked cell; and so forth until a cell has been assigned to each and every cell position.

Where the thermal model comprises groups of cell positions, and the cell rankings include performance brackets, the allocation may proceed as follows: the cell position group ranked as having the worst measure of cooling capability is allocated the best-ranked cell performance bracket. Cells from the best-ranked performance bracket are then allocated, possibly on a random basis, to cell positions in the worst-ranked group of cell positions. The cell position group ranked as having the second-worst measure of cooling capability is allocated the second-best ranked cell performance bracket. Cells from the second-best ranked performance bracket are then allocated, possibly on a random basis, to cell positions in second-worst ranked group of cell positions. This is repeated until a cell has been assigned to each and every cell position.

At 57, the allocation of cells to cell positions is recorded, for example in a cell packing sheet or an electronic file.

At 58, the battery module is assembled in accordance with the allocation, for example the allocation recorded in the cell packing sheet. For instance, a cell carrier frame corresponding to the design of the battery module may be provided. An assembler may then, for each cell position of the carrier frame, look up the unique identifier of the cell that has been allocated to that cell position, locate that cell within the carrier frame in said position, and make suitable electrical connections.

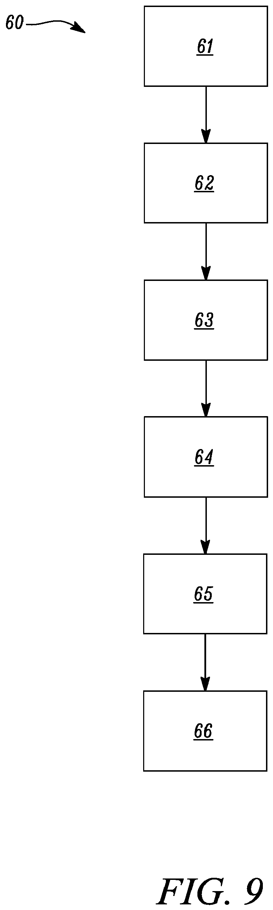

**Figure 9** is a flow chart illustrating a method 60 of assembling a battery pack in accordance with the present disclosure.

At 61, a design for at least a portion of a battery pack is identified. The portion of the battery pack may be an entire battery back (such as that shown in Figure 4, having multiple channels) or less than the entire battery pack, for example one channel of a multi-channel battery pack, one or multiple modules of a modular battery pack, or a fraction of a module such as one of the module halves illustrated in Figure 5A. Identifying the design may include designing a new battery pack (or a portion thereof) or selecting a pre-existing design for use.

In accordance with the disclosure, the portion of the battery pack to which the method is applied includes a plurality of cells of the same type. By "same type" it is meant that the cells are designed to have the same specification, with any differences between them mainly due to normal manufacturing variation. The cells may be of any suitable type. In the examples described above, the cells are cylindrical cells, for example 18650 cells. However other cells may be used, including but not limited to pouch cells, button cells, prismatic cells and other cells known in the art.

Within the portion of the battery pack, each cell of the plurality of cells has a cell position. Conveniently, the cell positions can be assigned unique identifiers (as described above with reference to Figure 5A) for tracking purposes. Any identification system could be used.

The number of cells in the portion of the battery pack may be at least 10, at least 50, at least 100, at least 250, at least 500 or at least 1,000. The plurality of cells of the portion may be arranged in an array having a first length and a second length perpendicular to the first length, and a ratio of the first and second lengths may be less than five, for example between 1 and 4, between 1 and 3 or between 1 and 2. The first and/or second length may be at least 0.5 metres, at least 0.75 metres, at least 1.0 metres, at least 1.25 metres or at least 1.5 metres. The gaps between adjacent cells may be less than 50mm, less than 40mm, less than 30mm or even less than 20mm. Aspects of the present disclosure may allow for a greater number of cells and/or smaller array aspect ratios and/or smaller cell spacing due to reduced cell heating in view of the matching between the DC cell internal resistance and the cell position cooling capability.

At 62, a thermal model for the portion of the battery pack is obtained. The thermal model includes, for each of the plurality of cell positions, a measure of a cooling capability associated with the cell position. The thermal model may be obtained as discussed above with reference to Figures 5A-5B. For example:

- Each cell position may be assigned to one of a plurality of groups, and the groups may be ranked according to a predicted or measured cell cooling capability. For example, there may be five groups A-E, with Group A corresponding to the best cooling capability and Group E corresponding to the worst cooling capability. Each group may contain the same number of cell positions or groups may be of different sizes.

- Each cell position may be ranked according to its predicted or measured cooling capability. For example, if the portion of the battery pack includes 100 cell positions, each cell position may be assigned a ranking between 1 and 100, with 1 corresponding to the best cooling capability and 100 corresponding to the worst cooling capability.

- Each cell position may be assigned a physical value, for example a cooling rate measured in Watts or another value that may be related to the cooling rate, according to predictions or measurements. In some cases a physical value and a ranking and/or grouping based on the physical value are included in the thermal model.

Obtaining the thermal model may comprise obtaining an existing thermal model for the portion of the battery pack, or alternatively constructing or generating one. Constructing the thermal model may comprise:

- Constructing a prototype or a partial prototype of the battery pack (or portion of the battery pack) and making measurements, for example as discussed above with reference to Figure 5B.

- Predicting cooling rates or other relevant physical values using a computer model or simulation of the battery pack (or the portion of the battery pack).

- Identifying descriptively similar or equivalent cell positions and defining one group per 'type' of position. Each cell position can then be assigned to a group according to its type of position. Groups can be ranked based on a measured or predicted cooling capability for the associated cell positions.

At 63, a plurality of battery cells of the same type is obtained. The number of cells is preferably greater than or equal to the number of cell positions in the portion of the battery pack. As described above with reference to steps 42-44 of Figure 6, cells may be discarded if they are, for example, damaged or otherwise visually unacceptable. The cells may also be given a unique identifier for tracking purposes.

At 64, for a plurality (e.g. all) of the obtained or remaining obtained battery cells, an indication of at least one measured property of the cell is obtained. The at least one measured property includes the DC internal resistance of the cell. Optionally, the at least one measured property also includes the charge capacity of the cell. The indication of the at least one measured property may be, for example:

- The actual DC internal resistance of the cell (measured in Ohms or another suitable unit) and, optionally, the actual capacity of the cell (measured in Coulombs or another suitable unit).

- A ranking of the cell's DC internal resistance compared to the other cells and, optionally, a ranking of the cell's capacity compared to the other cells.

- A ranked performance bracket into which the cell's DC internal resistance falls and, optionally, a ranked performance bracket into which the cell's capacity falls.

- A performance metric calculated based on the cell's DC internal resistance and, optionally, its capacity.

- A ranking based on such a performance metric, or a ranked performance bracket into which the performance metric falls.

Obtaining the indications of the measured property (or properties) of the cells may involve performing measurements on the cells, as described above with reference to Figure 6, and, if relevant, calculating performance metrics and/or determining rankings based on the measurements. Alternatively, the measurements, rankings and/or performance metrics may be predetermined, for example measurements may have been made at previous time.

At 65, for each of a plurality (e.g. all) of the cell positions, one of the obtained cells is allocated to the cell position. The allocation is based at least in part on the thermal model and the indications of the at least one measured property of the cells. The allocation may be performed as described above with reference to step 56 of Figure 7.

The allocation may be performed so as to minimise or at least reduce a temperature delta across the portion of the pack, the temperature delta being a difference, predicted or in use, between a temperature of the hottest cell in the portion and the temperature of the coolest cell in the portion of the pack. Similarly, the allocation may be performed so as to minimise or at least reduce a temperature difference between the hottest cell in the portion of the pack and the mean average cell temperature of all cells in the pack. The minimisation may be determined using a suitable optimisation algorithm and may be implemented using a computer, as will be understood by those skilled in the art.

At 66, the portion of the battery pack is assembled in accordance with its design and the allocations of the obtained cells from step 65. Assembling the portion of the pack may involve obtaining a carrier frame that provides a structure into which the cells can be positioned. For example, the carrier frame may comprise one or more arrays of slots, corresponding to the cell positions, for locating and retaining the cells. For each cell position, an assembler looks up which cell has been allocated to the cell position, obtains the allocated cell, and locates it within the carrier frame. The assembly may further include making suitable electrical connections, for example between the cells and one or more bus bars.

Parts of the method, for example, the determination of the thermal model and/or the allocation of cells to cell positions may be performed by a suitably programmed computer. For example, a computer program, which may be stored on a non-transitory computer readable medium, may be provided for performing one or more steps of the method 60.

It will be understood that the invention is not limited to the embodiments above-described and various modifications and improvements can be made without departing from the concepts described herein. Except where mutually exclusive, any of the features may be employed separately or in combination with any other features and the disclosure extends to and includes all combinations and sub-combinations of one or more features described herein.

**Claims**

1. A method (60) of assembling a battery pack from a plurality of battery cells of a same type, the method comprising:

identifying (61) a design for at least a portion of a battery pack, wherein the portion includes a plurality of battery cells and the design defines, for each of the plurality of cells, a cell position within the portion of the battery pack;

obtaining (62) a thermal model for the portion of the battery pack, the thermal model including, for each of the plurality of cell positions, a measure of a cooling capability associated with the cell position;

obtaining (63) a plurality of battery cells of the same type;

obtaining (64), for each of the obtained battery cells, an indication of at least one measured property of the cell, the at least one measured property of the cell including a DC internal resistance of the cell;

for a plurality of the cell positions, allocating (65) one of the obtained cells to the cell position based at least in part on the thermal model and the DC internal resistances of the cells; and

assembling (66) the portion of the battery pack in accordance with the design and the allocations of the obtained cells.

2. The method of claim 1, wherein allocating (65) the obtained cells to the cell positions comprises allocating cells having a relatively lower DC internal resistance to cell positions having a relatively higher cooling capability and allocating cells having a relatively higher DC internal resistance to cell positions having a relatively lower cooling capability.

3. The method (60) of claim 1 or claim 2, wherein the cells are allocated (65) to cell positions so as to reduce a predicted temperature delta across the portion of the battery pack, the temperature delta being a difference between a temperature of a hottest cell in the portion of the battery pack and a temperature of a coolest cell in the portion of the battery pack.

4. The method (60) of any one of the preceding claims, wherein the thermal model includes, for each of the plurality of cell positions, an indication of which one of a plurality of groups the cell position is associated with, wherein each of the plurality of groups corresponds to a different level of cooling capability, and each group comprises a plurality of cell positions.

5. The method (60) of claim 4, wherein each of the plurality of groups contains a plurality of cell positions whose positions are descriptively equivalent to all other cell positions in the group.

6. The method (60) of claim 5, wherein two cell positions are considered to be descriptively equivalent if they both meet one or more predefined criteria, the one or more predefined criteria being based on or more of:

whether or not a cell position is completely surrounded by other cell positions;

a number of cells positions that immediately neighbour the cell position;

a distance between the cell position and an exposed edge of the battery pack.

7. The method (60) of any one of the preceding claims, wherein the thermal model includes, for each cell position, a ranking of the cell position's cooling capability compared to the other cell positions.

8. The method (60) of any one of the preceding claims, wherein the at least one measured property further includes a charge capacity of the cell.

9. The method (60) of any one of the preceding claims, wherein the indication of the at least one measured property of the cell includes a ranking of the cell's DC internal resistance compared to the other cells and a ranking of the cell's charge capacity compared to the other cells.

10. The method (60) of any one of the preceding claims, wherein the indication of the at least one measured property of the cell includes a performance metric based on the cell's DC internal resistance and charge capacity.

11. The method (60) of any one of the preceding claims, wherein the indication of the at least one measured property of the cell includes an indication of which one of a plurality of performance brackets the cell falls into, wherein each performance bracket comprises at least one cell, and wherein the performance bracket into which a cell falls is based at least in part on the cell's DC internal resistance.

12. The method (60) of any one of the preceding claims, wherein the indication of the at least one measured property of the cell is or is based on a performance metric, the performance metric being a weighted sum of the cell's DC internal resistance and the cell's capacity or rankings thereof.

13. The method (60) of any one of the preceding claims, wherein:

the thermal model includes, for each of the plurality of cell positions, an indication of which one of a plurality of groups the cell position is associated with, each of the plurality of groups corresponds to a different level of cooling capability, and each group comprises a plurality of cell positions;

each of the plurality of obtained cells are assigned to one of a plurality of different performance brackets based at least in part on the indication of the least one measured property of the cell; and

cells assigned to a common performance bracket are allocated (65) cell positions belonging to a common cell position group.

14. The method (60) of any one of the preceding claims, wherein said at least a portion of the battery pack is: the whole battery pack; or one or more modules of the battery pack; or a subset of a set of cells, the set of cells including all cells of the battery pack.

15. A computer program operable, when executed by a computer, to:

receive a first input comprising a thermal model of at least a portion of a battery back, the thermal model including, for each of a plurality of battery cell positions of the portion of the battery pack, a measure of a cooling capability associated with the cell position;

receive a second input comprising, for each of a plurality of battery cells, an indication of at least one measured property of the cell, the at least one measured property including a DC internal resistance of the cell;

determine, for each of the cell positions of the thermal model, and based at least in part on the thermal model and the indications of the at least one measured property of the cells, a cell to cell position allocation; and

output the cell allocations.

## FIG. 1

**FIG. 2A**

**FIG. 2B**

FIG. 3

FIG. 4

EP 3 940 863 A1

Busbar
5
4
Half A 3
2
1

Cell, 1, 2, 3, 4...

Example, this is cell 3 on busbar 11

Example, this is cell 5 on busbar 6

Half B

Busbar
5
4
3
2
1

Cell, 1, 2, 3, 4...

*FIG. 5A*

Temperature Cut-off against SoC

80degC cell temperature = 40% SoC

—Cell Temperature

- - Battery SoC

Cell Temperature (C)

Battery SoC (%)

Time (s)

*FIG. 5B*

FIG. 6

*FIG. 7*

*FIG. 8A*

*FIG. 8B*

60

61

62

63

64

65

66

FIG. 9

Europäisches
Patentamt

European
Patent Office

Office européen
des brevets

# EUROPEAN SEARCH REPORT

**Application Number**

EP 21 18 2650

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2014/023914 A1 (COMMISSARIAT ENERGIE ATOMIQUE [FR]) 13 February 2014 (2014-02-13) * page 3, line 34 - page 14, line 25 * * figures 1-4 * * abstract * ----- | 1-15 | INV. H01M10/42 H01M10/48 H01M10/617 H01M10/625 H01M10/633 H01M10/651 H01M50/213 H01M50/233 H01M50/249 G01R31/385 G01R31/389 |
| A | JP 2004 303456 A (SANYO ELECTRIC CO) 28 October 2004 (2004-10-28) * abstract * ----- | 1-15 | |
| A | JP 2008 084691 A (TOYOTA MOTOR CORP) 10 April 2008 (2008-04-10) * abstract * ----- | 1-15 | |
| A | US 2010/047684 A1 (OKUMURA MOTOYOSHI [JP] ET AL) 25 February 2010 (2010-02-25) * abstract * ----- | 1-15 | |

TECHNICAL FIELDS
SEARCHED (IPC)

H01M
G01R

The present search report has been drawn up for all claims

| Place of search | Date of completion of the search | Examiner |
|---|---|---|
| Munich | 25 November 2021 | Mercedes González |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 21 18 2650

This annex lists the patent family members relating to the patent documents cited in the above-mentioned European search report.
The members are as contained in the European Patent Office EDP file on
The European Patent Office is in no way liable for these particulars which are merely given for the purpose of information.

25-11-2021

| Patent document cited in search report | | Publication date | Patent family member(s) | | Publication date |
|---|---|---|---|---|---|
| WO 2014023914 | A1 | 13-02-2014 | EP 2883267 A1<br>FR 2994511 A1<br>US 2015204948 A1<br>WO 2014023914 A1 | | 17-06-2015<br>14-02-2014<br>23-07-2015<br>13-02-2014 |
| JP 2004303456 | A | 28-10-2004 | NONE | | |
| JP 2008084691 | A | 10-04-2008 | JP 4952170 B2<br>JP 2008084691 A | | 13-06-2012<br>10-04-2008 |
| US 2010047684 | A1 | 25-02-2010 | JP 5319081 B2<br>JP 2008293703 A<br>US 2010047684 A1<br>WO 2008146587 A1 | | 16-10-2013<br>04-12-2008<br>25-02-2010<br>04-12-2008 |

EPO FORM P0459

For more details about this annex : see Official Journal of the European Patent Office, No. 12/82